# FASCICULE DE BREVET EUROPEEN

(11) **EP 0 690 574 B1**
(45) Date de publication et mention de la délivrance du brevet: **15.04.1998**
(21) Numéro de dépôt: 95410060.8
(22) Date de dépôt: 21.06.1995
(51) Int. Cl.: H03K 17/687, H03K 17/16

(54) **Circuit de commande d'une source de polarisation**
Steuerschaltung für eine Vorspannungsquelle
Control circuit for source of bias voltage

(30) Priorité: 27.06.1994 FR 9408119
(43) Date de publication de la demande: 03.01.1996
(73) Titulaire: SGS-THOMSON MICROELECTRONICS S.A., 94250 Gentilly (FR)
(72) Inventeur: Sirito-Olivier, Philippe, F-38100 Grenoble (FR); Morche, Colette, F-38240 Meylan (FR)
(74) Mandataire: de Beaumont, Michel

(56) Documents cités:
- EP-A- 0 503 888
- EP-A- 0 515 065
- US-A- 4 713 560

## Description

La présente invention concerne un circuit de commande d'une source de polarisation comportant des moyens de mise en veille.

Les dispositifs de mise en veille sont utilisés pour réduire l'énergie consommée d'un circuit pendant des périodes de non-utilisation en désactivant la source de polarisation, sans pour autant qu'il soit nécessaire de mettre le circuit hors service. Ils trouvent un intérêt tout particulier dans des systèmes à alimentation autonome, par exemple constituée de batteries rechargeables ou de piles, tels des capteurs à distance. De tels capteurs ont par exemple pour rôle de transmettre des informations à une centrale en cas de changement de l'état du capteur. Dans de tels systèmes, il est essentiel de limiter la consommation du capteur pendant les périodes où son état est stable. Pour ce faire, on met en veille la source de polarisation de ses organes d'émission lorsque le capteur est dans un état stable durant un intervalle de temps prédéterminé. Ceci permet de réduire la consommation du capteur pendant ces périodes. La source de polarisation est redémarrée, ou réactivée, dès que le signal de commande de mise en veille change d'état, indiquant que le capteur ne se trouve plus dans un état stable.

Un dispositif d'aide au démarrage d'une source de polarisation est habituellement implanté, dans le circuit de commande, pour permettre la mise en route de la source de polarisation. Un tel dispositif fonctionne généralement de manière indépendante du dispositif de mise en veille, il n'est utilisé qu'à la mise sous tension du circuit pour le démarrage initial de la source de polarisation suite à son extinction complète et est par la suite électriquement déconnecté de la source de polarisation. Classiquement, la source de polarisation n'est donc jamais complètement éteinte pendant ses périodes de veille. Les dispositifs de mise en veille existants réduisent la consommation du circuit et maintiennent la source de polarisation dans son état actif, dans la mesure où sinon, le circuit de commande ne disposerait plus de moyens pour redémarrer la source de polarisation, ceux-ci ayant été inhibés après la mise sous tension du circuit.

L'inconvénient de ces circuits existants est qu'il subsiste une consommation d'énergie même pendant les périodes de veille de la source de polarisation. Cette consommation provient de la consommation résiduelle de la source pendant ses périodes de veille, et du dispositif d'aide au démarrage.

De plus, une consommation transitoire importante se produit lors de la commutation du circuit depuis un état de fonctionnement nominal vers un état de veille de la source de polarisation. En effet, un tel circuit de commande comporte classiquement un dispositif logique à base d'inverseurs CMOS. Le rôle de ces inverseurs est de délivrer, à partir d'un signal de commande de mise en veille que reçoit le circuit de commande, un signal qui corresponde, pour le circuit de commande, à un signal logique. Pendant la transition du signal de commande de mise en veille entre un état correspondant à une absence de mise en veille et un état correspondant à une mise en veille, le courant qui circule dans les inverseurs présente un pic qui s'amortit en suivant le signal de commande de mise en veille. De ce fait, une consommation d'énergie inutile se produit à la commutation des inverseurs.

En outre, le signal de commande de mise en veille, bien que généralement lui-même un signal logique, évolue fréquemment entre deux potentiels qui ne correspondent pas forcément aux potentiels d'alimentation de la source de polarisation. Ce signal de commande de mise en veille ne constitue donc pas, dans ce cas, un signal logique du point de vue de la source de polarisation. Il en découle qu'un courant circule dans le dispositif logique pendant toute la durée où la source de polarisation est désactivée, ce qui induit une consommation d'énergie résiduelle importante. Cette consommation est d'autant plus importante que la différence entre le potentiel d'état bas du signal de commande de mise en veille et le potentiel de la borne négative de la tension d'alimentation est importante.

De telles consommations d'énergie sont néfastes pour l'autonomie des systèmes à alimentation autonome, mais ne peuvent être évitées dans les circuits classiques, notamment en raison du fait que la source de polarisation ne peut être complètement éteinte pendant les périodes de veille, faute de pouvoir alors la réactiver.

L'invention vise à remédier à ces inconvénients en proposant un circuit de commande d'une source de polarisation qui permette de supprimer toute consommation d'énergie pendant les périodes de veille de la source de polarisation, tout en permettant un retour de la source de polarisation dans son fonctionnement nominal. Elle vise également à limiter les périodes de consommation du circuit de commande aux périodes de commutation de la source de polarisation.

Pour atteindre cet objet, la présente invention prévoit un circuit de commande d'une source de polarisation comportant un dispositif de mise en veille et un dispositif d'aide au démarrage à consommation d'énergie nulle pendant les périodes de veille, dont des sorties respectives sont reliées à une entrée de commande de la source de polarisation, le dispositif d'aide au démarrage comportant un interrupteur d'inhibition de son fonctionnement pendant les périodes d'activité de la source de polarisation, commandé par la source de polarisation, le circuit comportant des moyens capacitifs reliés entre une entrée recevant un signal de commande de mise en veille, pour la réactivation du dispositif d'aide au démarrage, lors d'un changement d'état du signal de commande de mise en veille indiquant un besoin de réactivation de la source de polarisation.

Selon un mode de réalisation de l'invention, lesdits moyens capacitifs sont constitués d'un condensateur, relié entre une entrée du circuit de commande recevant le signal de commande de mise en veille, et une première entrée de commande du dispositif d'aide au démarrage.

Selon un mode de réalisation de l'invention, le circuit de commande comporte également des moyens de désactivation de l'ensemble de ses dispositifs pendant les périodes de veille de la source de polarisation.

Selon un mode de réalisation de l'invention, le dispositif de mise en veille est constitué d'un transistor MOS à canal P, dont la source est connectée à une borne positive d'une tension d'alimentation et dont le drain constitue une sortie du dispositif de mise en veille, reliée à l'entrée de commande de la source de polarisation, la grille du transistor MOS à canal P recevant le signal de commande de mise en veille.

Selon un mode de réalisation de l'invention, le dispositif d'aide au démarrage comporte deux transistors MOS à canal N montés en miroir entre une borne négative d'alimentation de la source de polarisation et, respectivement, le drain d'un transistor MOS à canal P et la sortie du dispositif de mise en veille ; la source du transistor MOS à canal P étant connectée à la borne positive d'alimentation, sa grille constituant une seconde entrée de commande du dispositif d'aide au démarrage ; les grilles des transistors MOS à canal N étant reliées au drain du transistor MOS à canal P qui constitue la première entrée de commande du dispositif d'aide au démarrage ; et le drain du transistor MOS à canal N relié à la sortie du dispositif de mise en veille, constituant la sortie du dispositif d'aide au démarrage envoyée sur l'entrée de commande de la source de polarisation.

Selon un mode de réalisation de l'invention, l'interrupteur d'inhibition du dispositif d'aide au démarrage comprend un transistor MOS à canal N placé entre la première entrée de commande du dispositif d'aide au démarrage et la borne négative d'alimentation de la source de polarisation, la grille de ce transistor étant reliée à une sortie de la source de polarisation.

Selon un mode de réalisation de l'invention, le circuit de commande comporte en outre un dispositif logique recevant sur une entrée le signal de commande de mise en veille, et dont une sortie est reliée à la seconde entrée de commande du dispositif d'aide au démarrage, ledit dispositif logique comportant au moins un premier inverseur à charge active commandée par la source de polarisation.

Selon un mode de réalisation de l'invention, le dispositif logique comporte un second inverseur commandé par la source de polarisation, une entrée du second inverseur étant reliée à une sortie du premier inverseur.

Selon un mode de réalisation de l'invention, la commande, par la source de polarisation, du deuxième inverseur est constituée de deux transistors MOS ; un transistor à canal N, dont la source est reliée à la borne négative de la tension d'alimentation et dont la grille est reliée à la sortie de la source de polarisation, étant relié, par son drain, au drain d'un transistor MOS à canal P, lui même monté en diode et en miroir avec un transistor à canal P du second inverseur.

Selon un mode de réalisation de l'invention, le dispositif logique comporte en outre au moins un troisième inverseur CMOS dont une entrée reçoit une sortie du deuxième inverseur et dont une sortie constitue la sortie du dispositif logique envoyée sur la seconde entrée de commande du dispositif d'aide au démarrage.

Le fait de prévoir des moyens propres à réactiver le dispositif d'aide au démarrage autorise une mise en veille par extinction complète de la source de polarisation, ce qui limite sa consommation d'énergie pendant les périodes de veille. Ces moyens de réactivation permettent de forcer la conduction dans la source de polarisation lorsqu'elle se trouve dans un état stable inactif provoqué par un signal de mise en veille.

Le fait de prévoir des moyens propres à désactiver l'ensemble des dispositifs du circuit de commande de la source de polarisation lorsque celle-ci est en veille, permet de réduire sensiblement la consommation en énergie du circuit de commande. On accroît ainsi l'autonomie du système dans lequel il est implanté.

Le recours à un inverseur à charge active commandée par la source de polarisation elle-même pour la constitution du dispositif logique rend la largeur du pic de courant à la commutation des inverseurs indépendante de la durée de commutation du signal de commande de mise en veille. Ainsi, on réduit la largeur de ce pic de courant dans la mesure où il disparaît dès que la source de polarisation est désactivée. De plus, on supprime toute consommation résiduelle dans le dispositif logique dans le cas où les potentiels des états logiques du signal de commande de mise en veille diffèrent des potentiels de la tension d'alimentation de la source de polarisation.

Le fait de commander le deuxième inverseur du dispositif logique par la source de polarisation permet de désactiver cet inverseur pendant les périodes de veille de la source de polarisation.

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :
la figure 1 représente un mode de réalisation d'un circuit de commande d'une source de polarisation selon l'invention ; et
la figure 2 représente, sous forme de chronogrammes, les tensions et courants les plus significatifs du circuit représenté à la figure 1 pendant une mise en veille et un redémarrage de la source de polarisation.

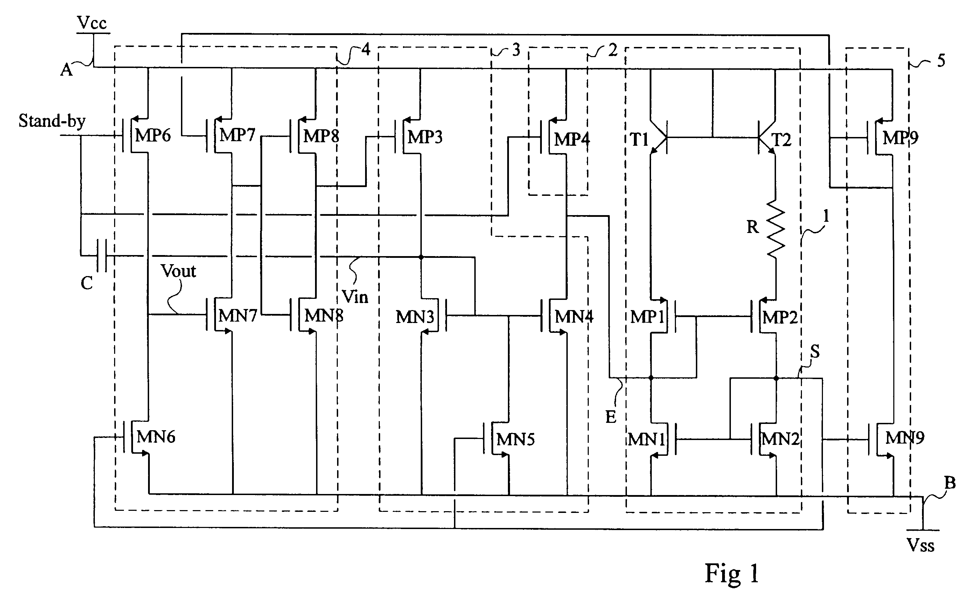

Comme le montre la figure 1, un circuit de commande d'une source de polarisation 1, selon l'invention, comporte essentiellement trois dispositifs. Un dispositif de mise en veille 2 de la source de polarisation 1 par arrêt total de sa consommation, un dispositif d'aide au démarrage 3 de la source de polarisation 1, et un dispositif logique 4 à charge active.

La source de polarisation 1 est alimentée entre deux bornes A, B aux potentiels Vcc, Vss d'une tension d'alimentation fournie par exemple par une batterie (non représentée). Un signal de commande de mise en veille "Stand-by" est reçu par le circuit de commande.

La source de polarisation 1 est, par exemple, une source de polarisation en ΔVbe/R. Une telle source de polarisation 1 est, par exemple, constituée de transistors montés en miroirs de courant et d'une résistance de polarisation R. Deux transistors bipolaires de type NPN T1, T2 ont leurs collecteurs et leurs bases connectés à la borne positive A, au potentiel Vcc, d'une tension d'alimentation. L'émetteur du transistor T1 est relié à la source d'un transistor MOS à canal P MP1. L'émetteur du transistor T2 est relié, par l'intermédiaire de la résistance de polarisation R, à la source d'un transistor MOS à canal P MP2. Ces deux transistors MOS supérieurs MP1, MP2 sont montés en miroirs et ont leurs grilles reliées au drain du transistor MP1. Le drain de chacun des transistors MP1, MP2 est respectivement relié au drain d'un transistor MOS à canal N MN1, MN2, dont la source est connectée à la borne négative B, au potentiel Vss, de la tension d'alimentation.

Les grilles de ces transistors MOS inférieurs MN1, MN2, qui sont également montés en miroir, sont reliées ensembles au drain du transistor MN2 qui constitue une borne de sortie S de la source de polarisation 1. Le rôle d'une telle source de polarisation 1 est d'activer la polarisation d'un ou plusieurs modules d'un circuit dans lequel elle est implantée, par la reproduction du courant qui la traverse sur une source de courant du module. Cette source de courant est par exemple constituée d'un transistor MOS monté en miroir sur les transistors inférieurs MN1, MN2 de la source de polarisation 1.

Une source de polarisation en ΔVbe/R comporte deux états stables. Un premier état, dit actif, correspond à un état dans lequel un courant circule dans chacune des branches T1, MP1, MN1 et T2, R, MP2, MN2 de la source de polarisation 1. Un second état, dit inactif, correspond à un état dans lequel aucun courant ne circule dans les branches T1, MP1, MN1 et T2, R, MP2, MN2 de la source de polarisation 1. Ce fonctionnement en mode bistable est lié aux tensions drain-source des transistors MOS MP1, MN1, MP2, MN2 qui bloquent la source de polarisation dans son état inactif. De fait, ces transistors sont bloqués tant que leur grille n'est pas portée à un potentiel, par rapport au potentiel de leur source, qui soit respectivement, inférieur pour un transistor à canal P, supérieur pour un transistor à canal N, d'une valeur correspondant à la tension seuil VT du transistor. De même, une fois qu'ils sont conducteurs, ils le resteront tant que le potentiel de leur grille n'atteindra pas ce potentiel. La source de polarisation 1 doit donc pouvoir être activée, ou démarrée, à la mise sous tension du circuit. Cette activation initiale est effectuée au moyen du dispositif d'aide au démarrage 3 qui sera décrit ci-dessous.

Lorsque la source de polarisation 1 est activée, le courant qui la traverse est proportionnel à la différence entre les tensions base-émetteur des transistors bipolaires T1, T2, et inversement proportionnel à la résistance de polarisation R. De fait, lorsque la source de polarisation 1 est active et équilibrée, c'est-à-dire lorsque les courants qui circulent dans chacune de ses branches T1, MP1, MN1 et T2, R, MP2, MN2 sont égaux, le courant Ib dans chacune des branches est égal à ΔVbe/R. ΔVbe représente la différence Vbe1-Vbe2 entre les sions base-émetteur des transistors T1, T2.

Cette source de polarisation 1 dispose d'une entrée de commande E constituée par les drains des transistors MP1, MN1, qui sont reliés aux sorties des dispositifs de mise en veille 2 et d'aide au démarrage 3.

Le dispositif d'aide au démarrage 3 comprend quatre transistors MOS MP3, MN3, MN4, MN5. La source du transistor MOS à canal P MP3 est connectée à la borne A, tandis que sa grille, qui constitue une seconde entrée de commande du dispositif d'aide au démarrage 3, est reliée à la sortie du dispositif logique 4. Le drain de ce transistor MP3 est relié au drain du transistor MOS à canal N MN3, monté en diode avec sa grille reliée à son drain. La source du transistor MN3 est connectée à la borne B. Les drains des transistors MP3, MN3, qui constituent une première entrée de commande Vin du dispositif d'aide au démarrage 3, sont également reliés à la grille du transistor MOS à canal N MN4 dont la source est connectée à la borne B. En d'autres termes, ce transistor MN4 est monté en miroir avec le transistor MN3. Le drain du transistor MN4, qui constitue la sortie du dispositif d'aide au démarrage 3 est relié aux drains des transistors MP1, MN1, qui constituent l'entrée de commande E de la source de polarisation 1.

Les grilles des transistors MN3, MN4 sont également reliées au drain du transistor à canal N MN5. La source de ce transistor MN5 est connectée à la borne B et sa grille est reliée à la borne de sortie S de la source de polarisation 1. En d'autres termes ce transistor MN5 est monté en miroir avec les transistors MOS inférieurs MN1, MN2 de la source de polarisation 1.

Un premier rôle du dispositif d'aide au démarrage 3 est, lors de la mise sous tension du circuit, de s'assurer que la source de polarisation 1 passe de son état inactif vers son état actif. Ce premier rôle est exposé ci-après alors qu'un second rôle du dispositif d'aide au démarrage 3 sera expliqué plus loin, en relation avec la mise en veille de la source de polarisation 1.

A la mise sous tension du circuit, le transistor MP3 conduit. On suppose pour cela que le signal "Stand-by" est dans son état haut V+ correspondant à l'absence de demande de mise en veille. Le potentiel de la grille des transistors MN3, MN4 est donc au potentiel Vcc, diminué de la chute de tension dans la résistance série du transistor MP3. Comme les sources des deux transistors MN3, MN4 sont au potentiel Vss, ces transistors MN3, MN4 conduisent également. Le transistor MN4 polarise alors les grilles des transistors MP1, MP2 au potentiel Vss, à la chute de tension dans la résistance série du transistor MN4 près. Ainsi ces transistors MP1, MP2 entrent en conduction, et par la liaison entre les grilles des transistors MN1, MN2 avec le drain du transistor MP2, les transistors MN1, MN2 entrent également en conduction. La source de polarisation 1 se trouve alors dans son état stable actif.

Par contre, les courants qui circulent dans les transistors MN1, MN2 sont déséquilibrés en raison de la conduction du transistor MN4. Mais, lorsque la source de polarisation 1 a démarré, le transistor MN5 se met à conduire dans la mesure où il est monté en miroir sur les transistors MN1, MN2. Cela provoque le blocage de ce transistor MN4, qui ne tire alors plus de courant sur la source de polarisation 1, ce qui permet d'équilibrer les courants qui circulent dans ses branches. Le transistor MN5 joue le rôle d'un interrupteur d'inhibition du dispositif d'aide au démarrage 3.

Pour provoquer une mise en veille de la source de polarisation, on utilise le signal "Stand-by" pour actionner le dispositif de mise en veille 2.

Ce dispositif de mise en veille 2 est constitué d'un transistor MOS à canal P MP4 qui reçoit sur sa grille le signal de commande de mise en veille "Stand-by". La source de ce transistor MP4 est reliée à la borne A de la tension d'alimentation tandis que son drain est relié à l'entrée de commande E de la source de polarisation 1.

L'apparition d'une demande de mise en veille, représentée par un changement d'état du signal "Stand-by" depuis son état haut V+ vers son état bas V- modifie la polarisation de la grille du transistor MP4. Par suite, ce transistor MP4 entre en conduction ce qui polarise les grilles des transistors MP1, MP2 de la source de polarisation 1 au potentiel Vcc, à la chute de tension dans la résistance série du transistor MP4 près. Ainsi, la source de polarisation est désactivée par le blocage des transistors MP1, MP2.

Cet état inactif de la source de polarisation 1 étant un état stable, la source de polarisation 1 restera inactive, même en cas de blocage du transistor MP4 suite à un nouveau changement d'état du signal "Stand-by". Ceci en raison des moyens qui seront décrits plus loin en relation avec la description du dispositif logique 4 et qui sont mis en oeuvre pour limiter la consommation du circuit à la commutation. Le redémarrage, ou réactivation de la source de polarisation 1 est provoqué par le dispositif d'aide au démarrage 3. Le second rôle de ce dispositif d'aide au démarrage 3 va maintenant être décrit.

Les drains des transistors MP3, MN3 qui constituent la première entrée Vin du dispositif d'aide au démarrage 3 sont reliés, par l'intermédiaire d'un condensateur C à l'entrée du circuit de commande recevant le signal "Stand-by". On utilise ainsi la transition du signal "Stand-by" depuis son état bas vers son état haut pour polariser les grilles des transistors MN3, MN4 et ainsi provoquer un redémarrage de la source de polarisation 1. Le rôle du condensateur C est double. D'une part, il évite de placer le transistor MN5 en court-circuit entre le potentiel Vss et le potentiel V+ du signal "Stand-by", ce qui provoquerait une consommation d'énergie importante. D'autre part il empêche que les transistors MP4 du dispositif de mise en veille 2 et MN4 du dispositif d'aide au démarrage 3 constituent un inverseur CMOS du signal "Stand-by". Ce condensateur C est essentiel, selon l'invention, pour obtenir le fonctionnement souhaité du circuit de commande.

On décrira ci-après la constitution du dispositif logique 4 dont le rôle est double. D'une part il transforme le signal "Stand-by" en un signal logique du point de vue du dispositif d'aide au démarrage 3. D'autre part, il permet de désactiver rapidement le dispositif d'aide au démarrage 3 à partir du signal de commande de mise en veille "Stand-by", lors d'un retour de la source de polarisation 1 dans son fonctionnement nominal.

Le dispositif logique 4 est constitué de trois inverseurs à base de transistors MOS MP6, MN6, MP7, MN7, MP8, MN8. Un premier inverseur de ce dispositif logique 4 comprend deux transistors MOS MP6, MN6, le transistor MOS à canal N MN6 représentant une charge active commandée par la source de polarisation 1. Le transistor MOS à canal P MP6 est connecté par sa source à la borne A de la tension d'alimentation tandis que sa grille reçoit le signal de commande de mise en veille "Stand-by". Le drain du transistor MP6 est relié au drain du transistor MOS à canal N MN6 dont la source est connectée à la borne B de la tension d'alimentation. La grille de ce transistor MN6 est reliée à la borne de sortie S de la source de polarisation 1. En d'autres termes, le transistor MN6 est monté en miroir avec les deux transistors MOS inférieurs MN1, MN2 de la source de polarisation 1. Les drains des transistors MP6, MN6 constituent la sortie Vout du premier inverseur du dispositif logique 4 qui est envoyée sur un deuxième inverseur à base de transistors MOS.

Ce deuxième inverseur comprend deux transistors MOS MP7, MN7. Le transistor MOS à canal N MN7 reçoit sur sa grille la sortie Vout du premier inverseur tandis que sa source est connectée à la borne B de la tension d'alimentation. Le drain de ce transistor MN7 est relié au drain du transistor MOS à canal P MP7 dont la source est connectée à la borne A de la tension d'alimentation. La grille de ce transistor MP7 est polarisée en fonction de la sortie S de la source de polarisation 1 au moyen de deux transistors MP9, MN9. Ces transistors MP9, MN9 constituent un étage de sortie 5 de la source de polarisation 1 qui sera décrit plus loin, en relation avec le fonctionnement du circuit de commande. Les drains des transistors MP7, MN7 constituent la sortie du deuxième inverseur du dispositif logique 4 qui est envoyée sur un troisième inverseur à base de transistors MOS.

Ce troisième inverseur est un inverseur CMOS classique. Il comprend deux transistors MOS MP8, MN8 dont les grilles sont reliées ensembles aux drains des transistors MP7, MN7. La source du transistor MOS à canal P MP8 est connectée à la borne A de la tension d'alimentation tandis que son drain est relié au drain du transistor à canal N MN8. La source du transistor MN8 est connectée à la borne B de la tension d'alimentation. Les drains des deux transistors MP8, MN8, constituent la sortie de ce second inverseur et du dispositif logique 4, qui est envoyée sur la grille du transistor MP3 constituant la seconde entrée de commande du dispositif d'aide au démarrage 3. La géométrie choisie pour cet inverseur CMOS est telle qu'il puisse commuter rapidement.

Le besoin de commander rapidement le transistor MP3 du dispositif d'aide au démarrage 3, à l'apparition d'une transition du signal "Stand-by", est lié à la géométrie de ce transistor MP3. Le transistor MP3 est choisi pour présenter une résistance série importante afin de limiter sa consommation hors des périodes de veille de la source de polarisation 1. Par conséquent il présente une capacité de grille importante qui requiert que l'on puisse lui envoyer rapidement du courant à l'apparition d'un signal de mise en veille si l'on souhaite le commander rapidement.

Le circuit de commande selon l'invention permet de désactiver la source de polarisation 1 par arrêt total de sa consommation, sans pour autant nuire à son redémarrage. En outre, il supprime toute consommation d'énergie pendant les périodes de veille et limite les périodes de consommation des dispositifs qui le constituent aux périodes de commutation de la source de polarisation 1.

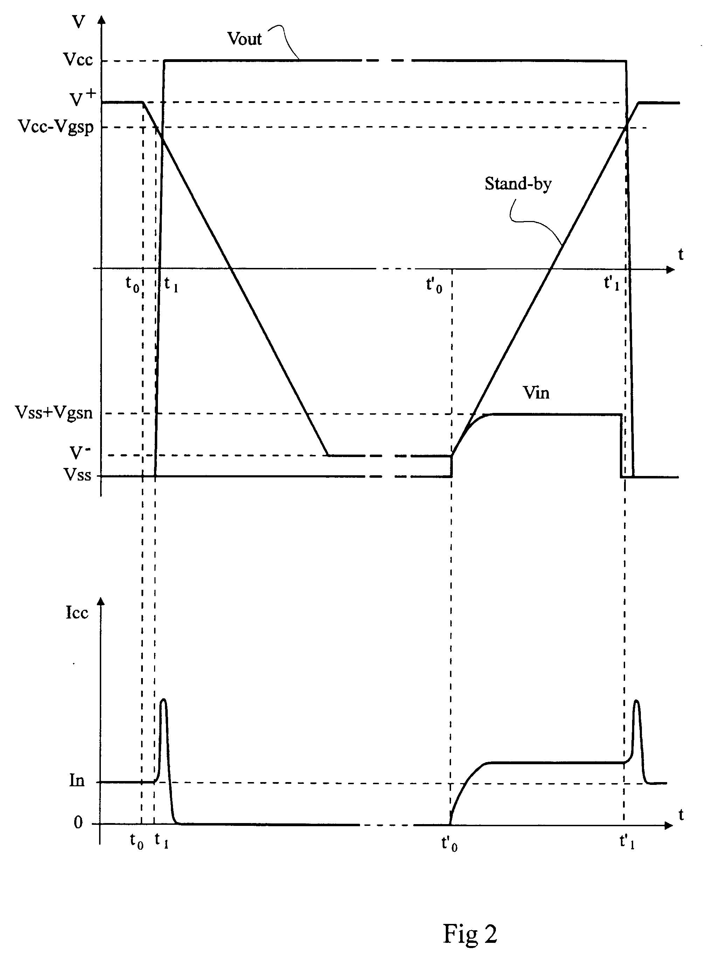

Ce fonctionnement est illustré par la figure 2 qui représente, sous forme de chronogrammes, le potentiel du signal "Stand-by", de la sortie Vout du premier inverseur du dispositif logique 4 et de l'entrée Vin du dispositif d'aide au démarrage, et le courant Icc consommé par l'ensemble du circuit.

En l'absence de commande de mise en veille sur l'entrée du circuit de commande, on suppose que le signal "Stand-by" est dans un état haut correspondant au potentiel V+. La source de polarisation 1 se trouvant dans son état actif, les transistors MP1, MP2, MN1, MN2 conduisent.

Comme il a été vu plus haut, le transistor MN5 conduit, et les deux transistors MN3, MN4 sont bloqués. Ainsi, aucun courant ne circule dans le dispositif d'aide au démarrage 3. De même, aucun courant ne circule dans le dispositif de mise en veille 2.

Le signal "Stand-by" étant dans son état haut, le transistor MP6 est bloqué et aucun courant ne circule dans le premier inverseur du dispositif logique 4. On suppose pour cela que le potentiel V+ de l'état haut du signal "Stand-by" est compris entre le potentiel Vcc et le potentiel Vcc-Vgsp, où Vgsp représente la tension seuil grille-source d'un transistor MOS à canal P, ici celle du transistor MP6. On suppose que tous les transistors MOS de même type présentent la même tension seuil grille-source dans la mesure où ils proviennent d'une même puce de circuit intégré. On peut abaisser le seuil de déclenchement du premier inverseur et permettre ainsi un fonctionnement pour un signal "Stand-by" dont le potentiel V+ serait inférieur, en intercalant un ou plusieurs transistors MOS à canal P, montés en diode, entre le transistor MP6 et la borne A.

A l'instant t0, le signal "Stand-by" entame une transition vers son état bas V- indiquant une demande de mise en veille. Tant que le signal "Stand-by" n'a pas atteint la valeur Vcc-Vgsp, la situation décrite ci-dessus subsiste. Le courant Icc consommé, correspond au courant dans la source de polarisation 1 qui est à sa valeur nominale In fixée par le ΔVbe/R.

Dès l'instant tl, où le signal "Stand-by" atteint la valeur Vcc-Vgsp, le transistor MP6 entre en conduction. Comme le transistor MN6 conduit, le courant qui le traverse présente un pic pour rejoindre le courant de la source de polarisation 1 sur lequel il est miroité. Au même instant tl, le transistor MP4 entre en conduction, ce qui provoque le blocage des transistors MP1, MP2 et la mise en veille de la source de polarisation 1. Aucun courant ne circule alors désormais dans la source de polarisation 1.

La désactivation de la source de polarisation 1 provoque le blocage de tous les transistors MN5, MN6, MN9 qui sont montés en miroir sur les transistors MN1, MN2. Le blocage du transistor MN5 libère les grilles des transistors MN3, MN4 du dispositif d'aide au démarrage 3 qui devient donc disponible pour réactiver la source de polarisation 1 en cas de besoin.

Le blocage du transistor MN6 supprime le courant dans le transistor MP6 et l'empêche ainsi de suivre la pente du signal "Stand-by". On réduit ainsi la consommation dans le premier inverseur en rendant la largeur de son pic indépendant de la durée de commutation du signal "Stand-by". Cette consommation dans l'inverseur s'arrête dès que la source de polarisation 1 est désactivée. En outre, aucune consommation résiduelle ne subsiste, même pour des potentiels des états hauts V+ et bas V- du signal "Stand-by" qui diffèrent des potentiels des bornes A et B. On réduit ainsi sa consommation d'énergie pendant la commutation.

Le blocage du transistor MN9 entraîne le blocage du transistor MP7 sous l'effet de sa commande par la source de polarisation 1. La commande du transistor MP7 est réalisée au moyen de l'étage de sortie 5. Cet étage de sortie est constitué de deux transistors MOS MP9, MN9. La source du transistor MOS à canal P MP9 est connectée à la borne A, tandis que sa grille est reliée à la grille du transistor MOS à canal P MP7 et que son drain est relié à sa propre grille et au drain du transistor MOS à canal N MN9. En d'autres termes, ce transistor MP9 est monté en diode et en miroir sur le transistor MP7. La source du transistor MN9 est connectée à la borne B et sa grille est reliée à la borne de sortie S de la source de polarisation 1. En d'autres termes ce transistor MN9 est monté en miroir avec les transistors inférieurs MN1, MN2 de la source de polarisation 1. Ainsi, lorsque la source de polarisation 1 est désactivée, les transistors MN9 et MP9 ne conduisent plus. Par conséquent, aucun courant ne peut circuler dans le transistor MP7. Le transistor MP3 se ferme alors sous l'effet du troisième inverseur du dispositif logique 4.

Toute consommation de courant est supprimée pendant les périodes de veille de la source de polarisation 1. En outre, ce résultat est obtenu quelle que soit la valeur du potentiel V- de l'état bas du signal de commande de mise en veille "Stand-by", pourvu qu'elle soit inférieure à Vcc-Vgsp.

Lorsque le signal de commande de mise en veille "Stand-by" entame une transition vers son état haut, indiquant une demande de réactivation de la source de polarisation 1, la commutation inverse s'effectue de la manière suivante.

A l'instant t'0, où le signal "Stand-by" entame sa transition vers le potentiel V+, le potentiel Vin à l'entrée du dispositif d'aide au démarrage 3 suit le potentiel du signal "Stand-by". Ceci sous l'effet du condensateur C, en étant limité à la valeur Vss+Vgsn, où Vgsn représentant la tension seuil grille-source d'un transistor MOS à canal N, ici celle du transistor MN3. Comme la grille du transistor MN4 se trouve au potentiel Vss+Vgsn, ce transistor entre en conduction. Le transistor MP4 étant également en conduction, un courant circule alors dans les transistors MN3, MP3, et MN4.

A l'instant t'1, où le potentiel du signal "Stand-by" atteint la valeur Vcc-Vgsp, les transistors MP4, MP6 se bloquent. Ainsi, le transistor MN4 peut de nouveau baisser le potentiel des grilles des transistors MP1 et MP2, ce qui provoque le redémarrage de la source de polarisation 1.

Une fois que la source de polarisation 1 a redémarré, les transistors MN5, MN6, MN9 se remettent à conduire.

La conduction du transistor MN6 polarise la grille du transistor MN7 au potentiel Vss, à la chute de tension dans la résistance série du transistor MN6 près.

La conduction dans le transistor MN5 polarise le potentiel de la grille du transistor MN4 au potentiel Vss, à la chute de tension dans la résistance série du transistor MN5 près. Par conséquent, cela provoque le blocage de ce transistor MN4, ce qui permet d'équilibrer les courants qui circulent dans les branches de la source de polarisation 1.

La conduction dans le transistor MN9 réactive le dispositif logique 4, par l'intermédiaire du transistor MP9, et ainsi le transistor MP3 conduit ce qui remet en route le dispositif d'aide au démarrage 3.

Du point de vue de la consommation en courant Icc, aucun courant n'est consommé, ni par le circuit de commande, ni par la source de polarisation 1, avant l'instant t'0. Entre les instants t'0 et t'1, la consommation correspond au courant traversant les transistors MN3, MP4, MN4. A l'instant t'1, où la source de polarisation 1 redémarre, il se produit un pic p correspondant à la commutation des transistors. Puis la consommation représente le courant In absorbé par la seule source de polarisation 1.

De fait, une fois que la source de polarisation 1 a redémarré, les dispositifs 2 et 4 du circuit de commande sont de nouveau désactivés du point de vue de leur consommation en courant.

Ainsi, la consommation en courant de ces dispositifs 2 et 4 est limitée aux périodes de commutation de la source de polarisation 1.

Pour permettre un fonctionnement optimal du circuit de commande selon l'invention, le condensateur C est choisi de sorte à causer un front raide à la transition du signal de commande de mise en veille. Par ailleurs, le transistor MP4 jouant le rôle d'un interrupteur, on cherchera à ce qu'il présente une faible résistance série pour pouvoir désactiver la source de polarisation 1 à l'apparition d'un signal de mise en veille. En d'autres termes on utilisera un transistor présentant une largeur de grille importante. Afin de limiter la consommation du dispositif d'aide au démarrage 3 pendant les périodes de fonctionnement nominal de la source de polarisation 1, le transistor MP3 sera choisi pour présenter un très faible rapport W/L. En d'autres termes, il présentera une longueur de grille nettement plus importante que sa largeur de grille. Dans le même ordre d'idée, on peut limiter l'amplitude du pic de courant, lors de la commutation du premier inverseur du dispositif logique 4, en dimensionnant le transistor MN6 avec un rapport W/L inférieur ou égal à celui du transistor MN2 de la source de polarisation 1.

Bien entendu, la présente invention est susceptible de diverses variantes et modifications qui apparaîtront à l'homme de l'art. En particulier, le choix des rapports entre les largeurs et les longueurs des grilles des transistors est fonction de l'utilisation à laquelle est destinée la source de polarisation. Dans le même ordre d'idée, chacun des composants décrits pourra être remplacé par un ou plusieurs éléments remplissant la même fonction.

## Revendications

1. Circuit de commande d'une source de polarisation (1) comportant un dispositif de mise en veille (2) et un dispositif d'aide au démarrage (3) à consommation d'énergie nulle pendant les périodes de veille, dont des sorties respectives sont reliées à une entrée de commande (E) de la source de polarisation (1), le dispositif d'aide au démarrage (3) comportant un interrupteur (MN5) d'inhibition de son fonctionnement pendant les périodes d'activité de la source de polarisation, commandé par la source de polarisation (1), caractérisé en ce qu'il comporte des moyens capacitifs (C) reliés entre une entrée recevant un signal (Stand-by") de commande de mise en veille, pour la réactivation du dispositif d'aide au démarrage (3), lors d'un changement d'état du signal ("Stand-by") de commande de mise en veille indiquant un besoin de réactivation de la source de polarisation (1).

2. Circuit de commande d'une source de polarisation (1) selon la revendication 1, caractérisé en ce que lesdits moyens capacitifs sont constitués d'un condensateur (C), relié entre l'entrée du circuit de commande recevant le signal ("Stand-by") de commande de mise en veille, et une première entrée de commande (Vin) du dispositif d'aide au démarrage (3).

3. Circuit de commande d'une source de polarisation (1) selon la revendication 1 ou 2, caractérisé en ce qu'il comporte des moyens de désactivation de l'ensemble de ses dispositifs (2, 3) pendant les périodes de veille de la source de polarisation (1).

4. Circuit de commande d'une source de polarisation (1) selon l'une quelconque des revendications 1 à 3, caractérisé en ce que ledit dispositif de mise en veille (2) est constitué d'un transistor MOS à canal P (MP4), dont la source est connectée à une borne positive (A) d'une tension d'alimentation et dont le drain constitue la sortie du dispositif de mise en veille (2), reliée à l'entrée de commande (E) de la source de polarisation (1), la grille du transistor MOS à canal P (MP4) recevant le signal de commande de mise en veille ("Stand-by").

5. Circuit de commande d'une source de polarisation (1) selon la revendication 4, caractérisé en ce que le dispositif d'aide au démarrage (3) comporte deux transistors MOS à canal N (MN3, MN4) montés en miroir entre une borne négative (B) d'alimentation de la source de polarisation (1) et, respectivement, le drain d'un transistor MOS à canal P (MP3) et la sortie du dispositif de mise en veille (2) ; en ce que la source du transistor MOS à canal P (MP3) est connectée à la borne positive (A) d'alimentation, sa grille constituant une seconde entrée de commande du dispositif d'aide au démarrage (3) ; en ce que les grilles des transistors MOS à canal N(MN3, MN4) sont reliées au drain du transistor MOS à canal P (MP3) qui constitue la première entrée de commande (Vin) du dispositif d'aide au démarrage (3) ; et en ce que le drain du transistor MOS à canal N (MN4) relié à la sortie du dispositif de mise en veille (2) constitue la sortie du dispositif d'aide au démarrage (3) envoyée sur l'entrée de commande (E) de la source de polarisation (1).

6. Circuit de commande d'une source de polarisation (1) selon la revendication 5, caractérisé en ce que l'interrupteur (MN5) d'inhibition du dispositif d'aide au démarrage (3) comprend un transistor MOS à canal N (MN5), placé entre la première entrée de commande (Vin) du dispositif d'aide au démarrage (3) et la borne négative (B) d'alimentation de la source de polarisation (1), la grille de ce transistor (MN5) étant reliée à une sortie (S) de la source de polarisation (1).

7. Circuit de commande d'une source de polarisation (1) selon la revendication 5 ou 6, caractérisé en ce qu'il comporte un dispositif logique (4) recevant sur une entrée le signal ("Stand-by") de commande de mise en veille, et dont une sortie est reliée à la seconde entrée de commande du dispositif d'aide au démarrage (3), ledit dispositif logique (4) comportant au moins un premier inverseur (MP6, MN6) à charge active (MN6) commandée par la source de polarisation (1).

8. Circuit de commande d'une source de polarisation (1) selon la revendication 7, caractérisé en ce que le dispositif logique (4) comporte un second inverseur (MP7, MN7) commandé par la source de polarisation (1), une entrée du second inverseur (MP7, MN7) étant reliée à une sortie (Vout) du premier inverseur (MP6, MN6).

9. Circuit de commande d'une source de polarisation (1) selon la revendication 8, caractérisé en ce que la commande, par la source de polarisation (1), du deuxième inverseur (MP7, MN7) est constituée de deux transistors MOS (MP9, MN9) ; un transistor à canal N (MN9), dont la source est reliée à la borne négative (B) de la tension d'alimentation et dont la grille est reliée à la sortie (S) de la source de polarisation (1), étant relié, par son drain, au drain d'un transistor MOS à canal P (MP9), lui même monté en diode et en miroir avec un transistor à canal P (MP7) du second inverseur (MP7, MN7).

10. Circuit de commande d'une source de polarisation (1) selon la revendication 8 ou 9, caractérisé en ce que le dispositif logique (4) comporte en outre au moins un troisième inverseur CMOS (MP8, MN8) dont une entrée reçoit une sortie du deuxième inverseur (MP7, MN7) et dont une sortie constitue la sortie du dispositif logique (4) envoyée sur la seconde entrée de commande du dispositif d'aide au démarrage (3).

## Patentansprüche

1. Steuerschaltung für eine Vorspannungsquelle (1), mit einer Stand-by-Vorrichtung (2) und einer Starthilfevorrichtung (3), mit Leistungsverbrauch Null während der Stand-by-Perioden, wobei die entsprechenden Ausgänge der Schaltung mit einem Steuereingang (E) der Vorspannungsquelle (1) verbunden sind und die Starthilfevorrichtung (3) einen durch die Vorspannungsquelle (1) gesteuerten Schalter (MN5) zur Sperrung bzw. Abschaltung ihres Betriebs während der Betriebs bzw. Einschaltperioden der Vorspannungsquelle aufweist,
dadurch gekennzeichnet, daß die Schaltung Kondensatormittel (C) aufweist, die mit einem Eingang verbunden sind, dem ein Stand-by-Steuersignal ('stand-by') zugeführt wird, zur Reaktivierung der Starthilfevorrichtung (3) bei einer Zustandsänderung des Stand-by-Steuersignals ('stand-by'), welche die Notwendigkeit der Reaktivierung der Vorspannungsquelle (1) anzeigt.

2. Steuerschaltung für eine Vorspannungsquelle (1) nach Anspruch 1,
dadurch gekennzeichnet, daß die genannten kapazitiven Schaltmittel aus einem Kondensator (C) bestehen, der zwischen dem Eingang der Steuerschaltung, welchem das Stand-by-Steuersignal ('Stand-by') zugeführt wird, und einem ersten Steuereingang (Vin) der Starthilfevorrichtung (3) liegt.

3. Steuerschaltung für eine Vorspannungsquelle (1) nach Anspruch 1 oder 2,
dadurch gekennzeichnet, daß sie Mittel zur Deaktivierung der Gesamtheit ihrer Vorrichtungen (2, 3) während der Stand-by-Perioden der Vorspannungsquelle (1) aufweist.

4. Steuerschaltung für eine Vorspannungsquelle (1) nach einem der Ansprüche 1 bis 3,
dadurch gekennzeichnet, daß die genannte Stand-by-Vorrichtung (2) aus einem P-Kanal-MOS-Transistor (MP4) besteht, dessen Source-Anschluß mit einer positiven Klemme (A) einer Speisespannung verbunden ist und dessen Drain-Anschluß den Ausgang der Stand-by-Vorrichtung (2) bildet, wobei dieser Ausgang mit dem Steuereingang (E) der Vorspannungsquelle (1) verbunden ist, und wobei das Gate des P-Kanal-MOS-Transistors (MP4) das Stand-by-Steuersignal ('Stand-by') zugeführt erhält.

5. Steuerschaltung für eine Vorspannungsquelle (1) nach Anspruch 4,
dadurch gekennzeichnet, daß die Starthilfevorrichtung (3) zwei N-Kanal-MOS-Transistoren (MN3, MN4) in Stromspiegelanordnung zwischen einer negativen Speisespannungsklemme (B) der Vorspannungsquelle (1) und dem Drain-Anschluß eines P-Kanal-MOS-Transistors (MP3) bzw. dem Ausgang der Stand-by-Vorrichtung (2) aufweist; daß der Source-Anschluß des P-Kanal-MOS-Transistors (MP3) mit der positiven Speisespannungsklemme (A) verbunden ist und sein Gate-Anschluß einen zweiten Steuereingang der Starthilfevorrichtung (3) bildet; daß die Gate-Anschlüsse der N-Kanal-MOS-Transistoren (MN3, MN4) mit dem Drain-Anschluß des P-Kanal-MOS-Transistors (MP3) verbunden ist, welcher den ersten Steuereingang (Vin) der Starthilfeeinrichtung (3) bildet; und daß der mit dem Ausgang der Stand-by-Vorrichtung (2) verbundene Drain-Anschluß des N-Kanal-MOS-Transistors (MN4) die Ausgangsgröße der Starthilfevorrichtung (3) bildet, die dem Steuereingang (E) der Vorspannungsquelle (1) zugeführt wird.

6. Steuerschaltung für eine Vorspannungsquelle (1) nach Anspruch 5,
dadurch gekennzeichnet, daß der Schalter (MN5) zur Sperrung bzw. Abschaltung der Starthilfevorrichtung (3) einen N-Kanal-MOS-Transistor (MN5) aufweist, der zwischen dem ersten Steuereingang (Vin) der Starthilfevorrichtung (3) und der negativen Speiseklemme (B) der Vorspannungsquelle (1) liegt, wobei der Gate-Anschluß dieses Transistors (MN5) mit einem Ausgang (S) der Vorspannungsquelle (1) verbunden ist.

7. Steuerschaltung für eine Vorspannungsquelle (1) nach Anspruch 5 oder 6,
dadurch gekennzeichnet, daß die Schaltung eine Logikvorrichtung (4) aufweist, die an einem Eingang das Stand-by-Steuersignal ('Stand-by') zugeführt erhält und von der ein Ausgang mit dem zweiten Steuereingang der Starthilfevorrichtung (3) verbunden ist, wobei die genannte Logikschaltung (4) wenigstens einen ersten Inverter (MP6, MN6) mit einer durch die Vorspannungsquelle (1) gesteuerten aktiven Last aufweist.

8. Steuerschaltung für eine Vorspannungsquelle (1) nach Anspruch 7,
dadurch gekennzeichnet, daß die Logikvorrichtung (4) einen zweiten durch die Vorspannungsquelle (1) gesteuerten Inverter (MP7, MN7) aufweist, wobei ein Eingang des zweiten Inverters (MP7, MN7) mit einem Ausgang (Vout) des ersten Inverters (MP6, MN6) verbunden ist.

9. Steuerschaltung für eine Vorspannungsquelle (1) nach Anspruch 8,
dadurch gekennzeichnet, daß die Steuerung des zweiten Inverters (MP7, MN7) durch die Vorspannungsquelle (1) von zwei MOS-Transistoren (MP9, MN9) gebildet wird; wobei ein N-Kanal-Transistor (MN9), dessen Source-Anschluß mit der negativen Speisespannungsklemme (B) und dessen Gate-Anschluß mit dem Ausgang (S) der Vorspannungsquelle (1) verbunden ist, über seinen Drain-Anschluß mit dem Drain-Anschluß eines P-Kanal-MOS-Transistors (MP9) verbunden ist, der seinerseits als Diode und in Spiegelschaltung mit einem P-Kanal-Transistor (MP7) des zweiten Inverters (MP7, MN7) geschaltet ist.

10. Steuerschaltung für eine Vorspannungsquelle (1) nach Anspruch 8 oder 9,
dadurch gekennzeichnet, daß die Logikvorrichtung (4) des weiteren wenigstens einen dritten CMOS-Inverter (MP8, MN8) aufweist, dessen einem Eingang eine Ausgangsgröße des zweiten Inverters (MP7, MN7) zugeführt wird und dessen einer Ausgang die Ausgangsgröße der Logikvorrichtung (4) bildet, welche dem zweiten Steuereingang der Starthilfevorrichtung (3) zugeführt wird.

## Claims

1. A control circuit for a bias source (1) including a stand-by device (2) and a start-up aid device (3), having a zero power consumption during the stand-by periods, having respective inputs connected to a control input (E) of the bias source (1), the start-up aid device (3) including a switch (MN5) for inhibiting its operation during the active periods of the bias source, controlled by the bias source (1), characterized in that it includes capacitive means (C) connected to an input receiving a stand-by control signal (stand-by), for reactivating the start-up aid device (3) when the "Stand-by" control signal changes state, indicating that the bias source (1) should be reactivated.

2. A control circuit for a bias source (1) according to claim 1, characterized in that said capacitive means include a capacitor (C) connected between an input of the control circuit receiving the stand-by control signal ("Stand-by"), and a first control input (Vin) of the start-up aid device (3).

3. A control circuit for a bias source (1) according to claim 1 or 2, characterized in that it includes means for deactivating the stand-by and start-up aid devices (2,3) during the stand-by periods of the bias source (1).

4. A control circuit for a bias source (1) according to any of claims 1 to 3, characterized in that said stand-by device (2) includes a p-channel MOS transistor (MP4) whose source is connected to a positive terminal (A) of a supply voltage, and whose drain constitutes an output of the stand-by device (2), connected to the control input (E) of the bias source (1), the gate of the p-channel MOS transistor (MP4) receiving the stand-by control signal ("Stand-by").

5. A control circuit for a bias source (1) according to claim 4, characterized in that the start-up aid device (3) comprises two n-channel MOS transistors (MN3, MN4) connected as a current mirror between a negative supply terminal (B) of the bias source (1), and, respectively, the drain of a p-channel MOS transistor (MP3) and the output of the stand-by device (2); in that the source of the p-channel MOS transistor (MP3) is connected to the positive supply terminal (A), its gate constituting a second control input of the start-up aid device (3); in that the gates of the n-channel MOS transistors (MN3, MN4) are connected to the drain of the p-channel MOS transistor (MP3), which constitutes the first control input (Vin) of the start-up aid device (3) ; and in that the drain of the n-channel MOS transistor (MN4), connected to the output of the stand-by device (2), constitutes the output of the start-up aid device (3) transmitted to the control input (E) of the bias source (1).

6. A control circuit for a bias source (1) according to claim 5, characterized in that the switch (MN5) for inhibiting the start-up aid device (3) includes an n-channel MOS transistor (MN5), located between the first control input (Vin) of the start-up aid device (3) and the negative supply terminal (B) of the bias source (1), the gate of this transistor (MN5) being connected to an output (S) of the bias source (1).

7. A control circuit for a bias source (1) according to claim 5 or 6, characterized in that it includes a logic device (4) receiving the stand-by control signal ("Stand-by") on an input, and having an output connected to the second control input of the start-up aid device (3), said logic device (4) including at least a first inverter (MP6, MN6) with an active load (MN6) controlled by the bias source (1).

8. A control circuit for a bias source (1) according to claim 7, characterized in that the logic device (4) includes a second inverter (MP7, MN7) controlled by the bias source (1), an input of the second inverter (MP7, MN7) being connected to an output (Vout) of the first inverter(MP6, MN6).

9. A control circuit for a bias source (1) according to claim 8, characterized in that the control of the second inverter (MP7, MN7) by the bias source (1) includes two MOS transistors (MP9, MN9); an n-channel transistor (MN9), whose source is connected to the negative terminal (B) of the supply voltage and whose gate is connected to the output (S) of the bias source (1), being connected, by its drain, to the drain of a p-channel MOS transistor (MP9), the latter being itself diode-connected and connected as a current mirror with a p-channel transistor (MP7) of the second inverter (MP7, MN7).

10. A control circuit for a bias source (1) according to claim 8 or 9, characterized in that the logic device (4) further includes at least a third CMOS inverter (MP8, MN8) having an input which receives an output of the second inverter (MP7, MN7), and an output which constitutes the output of the logic device (4) transmitted to the second control input of the start-up aid device (3).
